# EUROPEAN PATENT APPLICATION

(11) **EP 2 869 366 A1**
(43) Date of publication of application: **06.05.2015**
(21) Application number: 14190800.4
(22) Date of filing: 29.10.2014
(51) Int. Cl.: H01M 4/131, H01M 4/133, H01M 4/36, H01M 10/0525, H01M 10/44, H01M 4/02

(54) **Power storage device and power storage device control device**

(30) Priority: 30.10.2013 JP 2013224834
(71) Applicant: Funai Electric Co., Ltd., Daito city Osaka 574-0013 (JP)
(72) Inventor: Shimomura, Takeshi, Tsukuba City, Ibaraki 305-0047 (JP); Sumiya, Touru, Tsukuba City, Ibaraki 305-0047 (JP); Kihara, Shigeki, Tsukuba City, Ibaraki 305-0047 (JP); Suzuki, Masao, Tsukuba City, Ibaraki 305-0047 (JP); Ono, Masatoshi, Tsukuba City, Ibaraki 305-0047 (JP)
(74) Representative: Osha Liang SARL

(57) **Abstract**

A power storage device includes a positive electrode (10), a negative electrode (20), and a non-aqueous electrolyte. The negative electrode (20) comprises a plurality of types of negative electrode active materials, wherein each of the plurality of types has different lithium-ion absorption potentials.

## Description

### [Technical Field]

The present invention relates generally to a power storage device and a power storage device control device that controls the power storage device.

### [Background Technology]

Conventional lithium-ion batteries, a type of secondary battery, are known as power storage devices that have a high voltage and excel in energy density. Various mobile devices such as smartphones, consumer and industrial devices, OA devices, consumer electronics and tools, automobiles, and the like are equipped with lithium-ion batteries.

For example, a conventional lithium-ion battery has a positive electrode and a negative electrode provided so as to oppose the positive electrode via an electrolyte, where a discharge curve of the positive electrode has a plurality of plateaus (flat potential portions) (see Patent Document 1). Such a lithium-ion battery can provide a stable charge and discharge characteristic because the discharge curve of the positive electrode has the plurality of plateaus. As a result, remaining capacity and charge capacity can be easily detected.

### [Related Art Documents]

### [Patent Documents]

[Patent Document 1] Japanese Unexamined Patent Application Publication No. 2011-222497

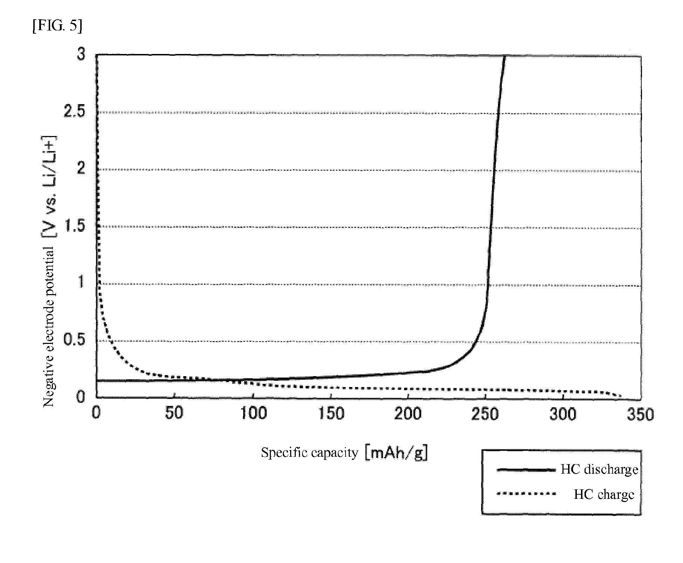

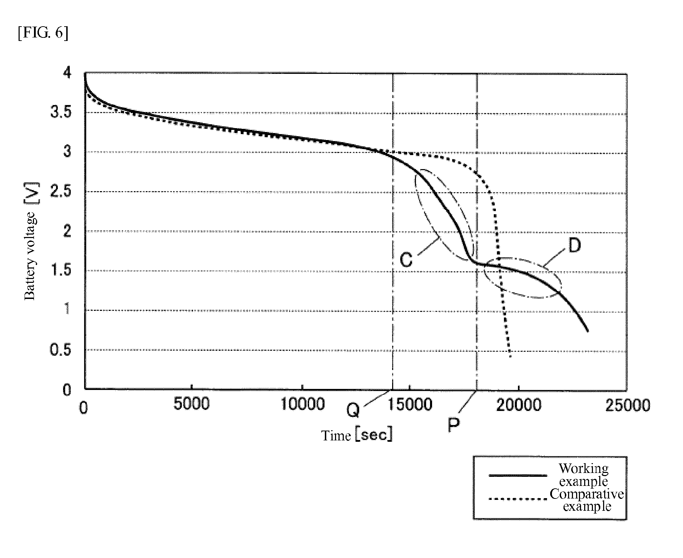

However, even if a discharge curve of a positive electrode has a plurality of plateaus as in the lithium-ion battery described in Patent Document 1, a potential of the negative electrode rises significantly at the final stage of discharge because lithium-ions intercalated in the negative electrode escape at the final stage of discharge, as illustrated by the solid line in FIG. 5 for example. Therefore, as illustrated by the dashed line in FIG. 6 for example, because a voltage of the lithium-ion batteries drops rapidly at the final stage of discharge, there is a danger of over-discharge if a threshold voltage at an end of discharge is not set in advance, with an allowance in consideration of variation, so discharge ends before a battery voltage drops rapidly, or if a complex control for precisely capturing a rapid voltage drop is not performed. Therefore, to prevent over-discharge, a microcomputer that manages charge and discharge is mounted on a battery pack to successively manage a state of the batteries. The lithium-ion batteries are vulnerable to over-discharge, and a battery's function deteriorates if discharged excessively. This may be a disadvantage of the lithium-ion batteries compared to electric double-layer capacitors that display a linear voltage change or the like.

Here, "Battery voltage (= voltage of lithium-ion battery)" on the vertical axis in FIG. 6 is "(potential of positive electrode) - (potential of negative electrode)." Therefore, even if the discharge curve of the positive electrode has the plurality of plateaus as in the lithium-ion battery described in Patent Document 1, the battery voltage cannot be suppressed from dropping rapidly at the final stage of discharge if the rising potential of the negative electrode is not suppressed at the final stage of discharge. Therefore, even if the discharge curve of the positive electrode has the plurality of plateaus, a risk of over-discharge persists unless the threshold voltage at the end of discharge is set in advance with the allowance or complex control for precisely capturing the rapid voltage drop is performed.

### [Summary of the Invention]

One or more embodiments of the invention provide a power storage device whose voltage drop at a final stage of discharge is slower than conventional power storage devices and a power storage device control device for controlling the power storage device.

According to one or more embodiments, a power storage device may comprise: a positive electrode; a negative electrode; and a non-aqueous electrolyte, wherein the negative electrode may comprise a plurality of types of negative electrode active materials, and each of the plurality of types may have different lithium-ion absorption potentials.

According to one or more embodiments, the negative electrode may comprise a first negative electrode active material and a second negative electrode active material whose lithium-ion absorption potential is higher than that of the first negative electrode active material. Further, according to one or more embodiments, the first negative electrode active material may comprise at least one of a polyacenic organic semiconductor, a graphitic material, graphitizable carbon, non-graphitizable carbon, and low-temperature co-fired carbon; and the first negative electrode active material may have a lithium-ion absorption potential of approximately 0.4V or less. Further, according to one or more embodiments, the second negative electrode active material may comprise at least one of a lithium titanium oxide expressed by the general formula Li₄TisO₁₂, and a hydrogen titanium oxide expressed by the general formula H₂Ti₁₂O₂₅. Further, according to one or more embodiments, the second negative electrode active material may have a lithium-ion absorption potential higher than approximately 0.4V. Further, according to one or more embodiments, the positive electrode may comprise a positive electrode active material comprising at least one of an inorganic oxide and a conductive polymer.

According to one or more embodiments, a power storage device control device may comprise: a controller that controls discharge of the power storage device as described above; and a detector that monitors discharge of the power storage device. Further, according to one or more embodiments, the detector may monitor a discharge curve of the power storage device and detect a point when an absolute value of a gradient of the discharge curve falls below a second threshold from among points in a period at and after the absolute value of the gradient of the discharge curve surpasses the first threshold, wherein the second threshold may be less than or equal to the first threshold; and the controller may stop discharge of the power storage device when the detector detects the point that falls below the second threshold. Further, according to one or more embodiments, the detector may monitor a discharge curve of the power storage device, and detect a point when a voltage of the power storage device falls below a threshold, and the controller may stop discharge of the power storage device when the detector detects that the voltage has fallen below the threshold.

According to one or more embodiments of the present invention, because a discharge curve of the negative electrode may have a plurality of plateaus, the voltage drop of the power storage device at the final stage of discharge becomes slow. Because of this, for example, a danger of over-discharge can be avoided without setting in advance with an allowance a threshold voltage at the final stage of discharge or performing a complex control for precisely capturing a rapid voltage drop.

Furthermore, according to one or more embodiments of the present invention, the danger of over-discharge can be avoided because discharge of the power storage device can be stopped when the voltage drop of the power storage device at the final stage of discharge is slow.

### [Brief Description of Drawings]

FIG. 1 is an exploded perspective view illustrating an example of a power storage device according to one or more embodiments of the present invention.
FIG. 2 is a cross-sectional view illustrating the example of the power storage device according to one or more embodiments of the present invention.
FIG. 3 is a block diagram illustrating a configuration of a power storage device control device according to one or more embodiments of the present invention.
FIG. 4 is a graph illustrating charge and discharge curves of a negative electrode provided by a lithium-ion battery according to one or more embodiments of a working example.
FIG. 5 is a graph illustrating charge and discharge curves of a negative electrode provided by a conventional lithium-ion battery of a comparative example.
FIG. 6 is a graph illustrating discharge curves of the lithium-ion batteries according to one or more embodiments of the working example and the comparative example.

### [Detailed Description of Embodiments]

Embodiments of the present invention will be described below with reference to the drawings. However, the scope of the invention is not limited to the illustrated examples.

### (Lithium-ion battery)

First, a power storage device (e.g., lithium-ion battery 1) according to one or more embodiments of the present invention will be described.

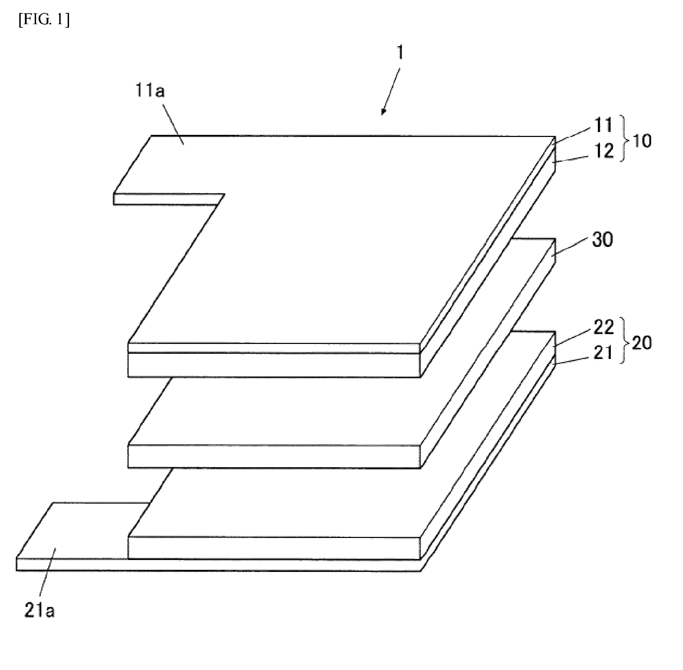

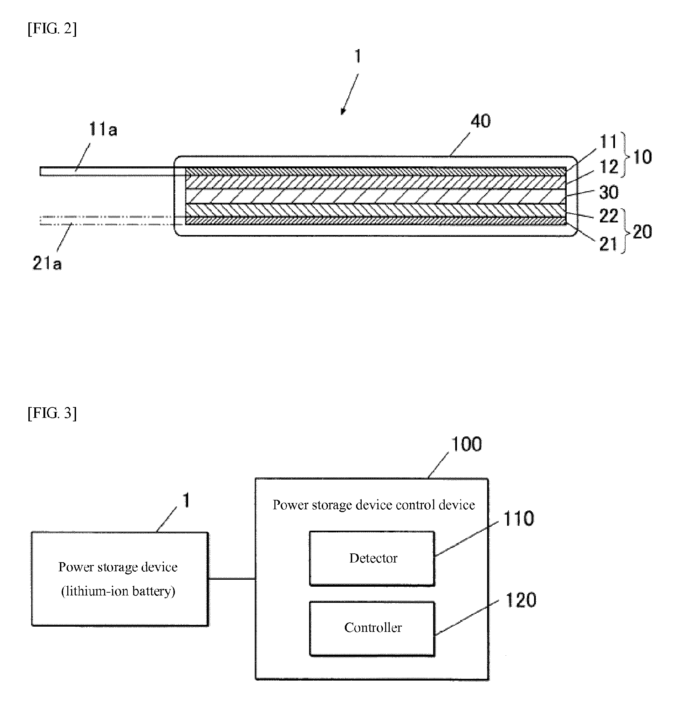

FIG. 1 is an exploded perspective view illustrating an example of the power storage device (e.g., lithium-ion battery 1) according to one or more embodiments of the present invention, and FIG. 2 is a cross-sectional view illustrating the example of the power storage device (e.g., lithium-ion battery 1) according to one or more embodiments of the present invention.

As illustrated in FIGS. 1 and 2, the lithium-ion battery 1 may be a power storage device comprising: a positive electrode current collector 11 and a negative electrode current collector 21 disposed opposing each other; a positive electrode active material layer 12 formed on a surface (facing the negative electrode current collector 21) of the positive electrode current collector 11 and a negative electrode active material layer 22 formed on a surface (facing the positive electrode current collector 11) of the negative electrode current collector 21; a separator 30 disposed between the positive electrode active material layer 12 and the negative electrode active material layer 22 and impregnated with a non-aqueous electrolyte; and a housing body 40 for housing the above. In FIG. 1, illustration of the housing body 40 is omitted.

Furthermore, with a multilayer type, the positive electrode active material layer 12 and the negative electrode active material layer 22 may be applied on both surfaces of each current collector and packaged by being stacked in parallel and in series.

The current collectors 11, 21 may electrically connect the active material layers 12, 22 and an external circuit. Terminals 11a, 21 a pulled out to an outer portion of the housing body 40 and connected to the external circuit may be formed on the current collectors 11, 21. A material of the current collectors 11, 21 may be any material that has characteristics of (1) high electron conductivity, (2) existing stably inside the device, (3) being able to reduce a volume inside the device (being thin), (4) having a small weight per unit volume (being lightweight), (5) being easy to process, (6) having strength, (7) having adhesion (mechanical adhesion), or (8) not corroding or dissolving due to an electrolyte solution, and the like, and may be a metallic electrode material such as platinum, aluminum, gold, silver, copper, titanium, nickel, iron, or stainless steel, for example, or a nonmetallic electrode material such as carbon, a conductive rubber, or a conductive polymer. Moreover, it is also possible to form at least an inner surface of the housing body 40 with a metallic electrode material and/or a nonmetallic electrode material and provide the active material layers 12, 22 on this inner surface. In this situation, the housing body 40 also serves as the current collectors 11, 21.

Here, a positive electrode 10 for the lithium-ion battery 1 according to one or more embodiments of the present invention may be configured by the positive electrode current collector 11 and the positive electrode active material layer 12 provided on a top surface of the positive electrode current collector 11. Moreover, a negative electrode 20 for the lithium-ion battery 1 according to one or more embodiments of the present invention may be configured by the negative electrode current collector 21 and the negative electrode active material layer 22 provided on a top surface of the negative electrode current collector 21.

The active material layers 12, 22 may include an active material, a conductive additive, and a binder resin and are provided on the top surface of the current collectors 11, 21.

An inorganic oxide such as LiCoO₂, LiNiO₂, LiNi_{0.8}Co_{0.15}Al_{0.05}O₂, LiNi_{1/3}Mn_{1/3}Co_{1/3}O₂, LiMn₂O₄, or LiFePO₄ or a conductive polymer such as polyacene, polypyrrole, polythiophene, or polyaniline may be included as the active material (positive electrode active material) in the positive electrode active material layer 12.

Furthermore, a plurality of types of negative electrode active materials whose lithium-ion absorption potentials mutually differ may be included as the active material (negative electrode active material) in the negative electrode active material layer 22. Specifically, the negative electrode active material layer 22 may include two types of negative electrode active materials: a first negative electrode active material whose lithium-ion absorption potential is 0.4 V (vs. Li/Li⁺) or less and a second negative electrode active material whose lithium-ion absorption potential is higher than 0.4 V (vs. Li/Li⁺).

According to one or more embodiments, a polyacenic organic semiconductor (PAS), a graphitic material (natural graphite, synthetic graphite, modified graphite), graphitizable carbon, non-graphitizable carbon, or low-temperature co-fired carbon may be used as the first negative electrode active material, but the negative electrode active material layer 22 may include both the graphitizable carbon and the non-graphitizable carbon as the first negative electrode active material. Moreover, the first negative electrode active material is not limited to the graphitizable carbon and the non-graphitizable carbon but can be suitably and arbitrarily replaced with a material that functions as a negative electrode active material, such as coke, various types of graphite materials, carbon fibers, resin-fired carbon, pyrolytic vapor-grown carbon, meso-carbon microbeads (MCM), mesophase pitch-based carbon fibers, graphite whiskers, pseudo-isotropic carbon (PIC), or a fired body of a natural material.

Furthermore, according to one or more embodiments, a lithium titanium oxide (LTO) expressed by the general formula Li₄Ti₅O₁₂ or a hydrogen titanium oxide (HTO) expressed by the general formula H₂Ti₁₂O₂₅ is used, but the negative electrode active material layer 22 may include both the LTO and the HTO as the second negative electrode active material. Moreover, the second negative electrode active material is not limited to the LTO or the HTO but can be suitably and arbitrarily replaced with a material that functions as a negative electrode active material and is a material whose lithium-ion absorption potential is higher than that of the first negative electrode active material.

The conductive additive included in the active materials 12, 22 may lower an internal resistance of the lithium-ion battery 1. A carbon black such as acetylene black, furnace black, channel black, thermal black, or ketjenblack, for example, may be used as the conductive additive.

The binder resin included in the active materials 12, 22 may fix the active material and the conductive additive to each other in a mixed state. Styrene-butadiene rubber (SBR), polytetrafluoroethylene (PTFE), polyvinylidene fluoride (PVdF), tetrofluoroethylene-propylene (FEPM), an elastomer binder, or the like can be used as the binder resin, which can be coated on a collector electrode (current collector) after kneading by a wet process or a dry process.

The separator 30 may be disposed between the adjacent positive electrode 10 and the negative electrode 20 to prevent the positive electrode 10 and the negative electrode 20 from contacting and shorting in the housing body 40. An insulating material that can hold a non-aqueous electrolyte can be used as a material of the separator 30. For example, a film or the like, such as polyolefin, polytetrafluoroethylene (PTFE), polyethylene, cellulose, or polyvinylidene fluoride (PVdF) can be used as the separator 30.

The non-aqueous electrolyte impregnated in the separator 30 may be a non-aqueous electrolyte where a lithium salt (supporting salt) such as LiPF₆, LiBF₄, or LiClO₄ is dissolved in a predetermined organic solvent and may conduct lithium ions by being interposed between the positive electrode 10 and the negative electrode 20.

Ethylene carbonate (EC), ethyl methyl carbonate (EMC), propylene carbonate (PC), diethyl carbonate (DEC), dimethyl carbonate (DMC), or the like, for example, can be used as the predetermined organic solvent.

The housing body 40 may house a stacked body of the current collectors 11, 21, the active material layers 12, 22, and the separator 30 that impregnates and holds the non-aqueous electrolyte. Here, the housing body 40 and the current collectors 11,21 may be insulated from each other.

A laminate film material configured from aluminum, stainless steel, titanium, nickel, platinum, gold, or the like, a laminate film material configured from an alloy of the above, or the like can be used as a material of the housing body 40.

Next, an example of a manufacturing method of the lithium-ion battery 1 of one or more embodiments will be described.

First, a positive electrode active material slurry may be produced by mixing the positive electrode active material, the conductive additive for the positive electrode active material layer 12, and the binder resin for the positive electrode active material layer 12.

Furthermore, a negative electrode active material slurry may be produced by kneading the first negative electrode active material, the second negative electrode active material, the conductive additive for the negative electrode active material layer 22, and the binder resin for the negative electrode active material layer 22.

Next, the positive electrode 10 may be produced by placing the positive electrode active material slurry on the positive electrode current collector 11, applying pressure thereon, and forming the positive electrode active material layer 12 on the top surface of the positive electrode current collector 11.

Furthermore, the negative electrode 20 may be produced by placing the negative electrode active material slurry on the negative electrode current collector 21, applying pressure thereon, and forming the negative electrode active material layer 22 on the top surface of the negative electrode current collector 21.

Next, a battery main body may be produced by disposing the positive electrode 10 and the negative electrode 20 so the positive electrode active material layer 12 and the negative electrode active material layer 22 oppose each other and interposing the separator 30 impregnated with the non-aqueous electrolyte therebetween.

Next, the battery main body may be housed in the housing body 40, and the housing body 40 is vacuum sealed. This is one example of manufacturing the lithium-ion battery 1.

In FIG. 1, a lithium-ion battery 1 where the positive electrode 10, the negative electrode 20, and the separator 30 are rectangular is illustrated, but a shape of the positive electrode 10, the negative electrode 20, and the separator 30 can be suitably and arbitrarily changed and may be circular, for example.

### (Power storage device control device)

Next, a power storage device control device 100 according to one or more embodiments of the present invention will be described.

FIG. 3 is a block diagram illustrating a configuration of the power storage device control device 100 according to one or more embodiments of the present invention.

The power storage device control device 100 may be a microcomputer or the like that manages charge and discharge to prevent over-discharge of the lithium-ion battery 1 and, as illustrated in FIG. 3, may comprise a detection unit or detector 110 that, by monitoring a discharge curve of the lithium-ion battery 1, detects a point P when an absolute value of a gradient of the discharge curve falls below a second threshold (≤ first threshold) from among points in a period at and after the absolute value of the gradient of the discharge curve surpasses the first threshold and a control unit or controller 120 that controls charge and discharge of the lithium-ion battery 1.

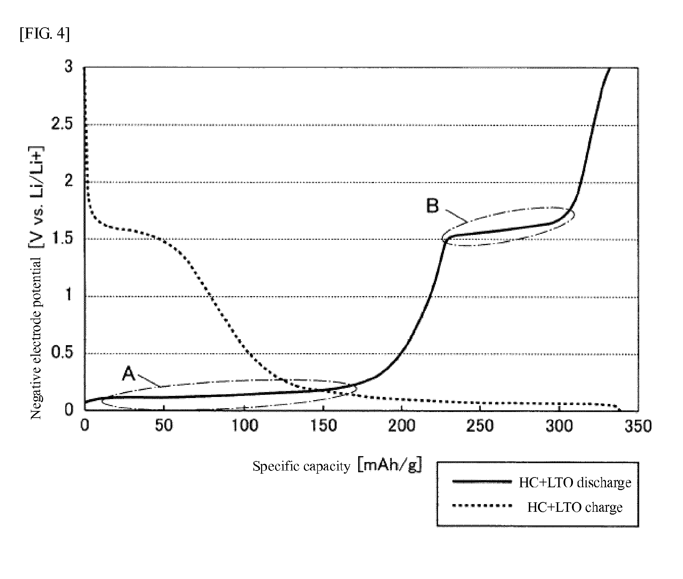

According to one or more embodiments, the lithium-ion battery 1 may include two types of negative electrode active materials whose lithium-ion absorption potentials mutually differ in the negative electrode 20. For example, the lithium-ion battery 1 may include the first negative electrode active material and the second negative electrode active material whose lithium-ion absorption potential is higher than that of the first negative electrode active material. Because of this, as illustrated by the solid line in FIG. 4, a discharge curve of the negative electrode 20 may become a curve having a plateau (flat potential portion) in two locations, near the lithium-ion absorption potential of the first negative electrode active material (region A encircled by the one-dot chain line in FIG. 4) and near the lithium-ion absorption potential of the second negative electrode active material (region B encircled by the one-dot chain line in FIG. 4).

Therefore, as illustrated by the solid line in FIG. 6, the discharge curve of the lithium-ion battery 1 may also become a curve having a plateau of two stages. In this example, first, a plateau ("upper-stage plateau") appears, then, as discharge progresses, the absolute value of the gradient of the discharge curve gradually approaches the first threshold; the absolute value of the gradient of the discharge curve eventually surpasses the first threshold, and a voltage drop becomes rapid (region C encircled by the one-dot chain line in FIG. 6). Then, as discharge further progresses and a value of a battery voltage arrives near a predetermined value, the absolute value of the gradient of the discharge curve falls below the second threshold, a plateau ("lower-stage plateau") appears, and the voltage drop becomes slow (region D encircled by the one-dot chain line in FIG. 6).

The detector 110 may monitor the discharge curve of the lithium-ion battery 1 and detect the point P when the absolute value of the gradient of the discharge curve falls below the second threshold (first threshold ≥ second threshold) from among each of the points in the period at and after the point when the absolute value of the gradient of the discharge curve surpasses the first threshold, that is, a boundary portion between the region C whose voltage drop is rapid and the region D whose voltage drop is slow.

Furthermore, the controller 120 may be configured to stop discharge of the lithium-ion battery 1 when the detector 110 detects the point P that falls below the second threshold.

According to one or more embodiments, the first threshold and the second threshold are not defined unconditionally because they depend on a type, a blending quantity, a thickness of an active material layer, and the like of the first negative electrode active material and the second negative electrode active material but can be suitably and arbitrarily set if the first threshold can detect an end of the upper-stage plateau and the second threshold can detect at least a start of the lower-stage plateau.

Because a negative electrode of a conventional lithium-ion battery does not include a plurality of types of negative electrode active materials whose lithium-ion absorption potentials mutually differ, as illustrated by the dashed line in FIG. 6, a battery voltage drops rapidly at a final stage of discharge. Therefore, with conventional lithium-ion batteries, there is a danger of over-discharge if a threshold voltage at an end of discharge is not set in advance, with an allowance in consideration of variation, so discharge ends before a battery voltage drops rapidly, or if a complex control for precisely capturing a rapid voltage drop is not performed. When the threshold voltage at the end of discharge is set in advance with the allowance, because discharge must be ended despite there being a sufficient remaining capacity, an energy density (energy (power amount) able to be extracted per unit mass (or unit volume)) becomes lower. Moreover, in order to prevent the energy density from becoming low, the complex control for precisely capturing the rapid voltage drop and end discharge may be performed while the battery voltage is dropping rapidly, but in this situation, because a complex control system is needed, there is a cost involved. Moreover, in this situation, the equipped microcomputer (microcomputer that manages charge and discharge to prevent over-discharge) may learn points where discharge is possible that differ according to a variation of the battery, but a situation may occur where these points change due to an accumulation of errors, producing deviations in estimated values of a capacity and thereby significantly reducing the energy density.

In contrast, because the discharge curve of the lithium-ion battery 1 according to one or more embodiments may have the plateau of two stages, discharge of the lithium-ion battery 1 can be stopped substantially simultaneously as the start of the lower-stage plateau by detecting the point P when the discharge curve falls below the second threshold. Therefore, for example, the danger of over-discharge can be avoided without setting in advance, with the allowance, the threshold voltage at the end of discharge, or performing the complex control for precisely capturing the rapid voltage drop.

For example, according to one or more embodiments of the invention, the energy density can be increased compared to that of conventional lithium-ion batteries because there is no need to set in advance, with the allowance, the threshold voltage at the end of discharge. Further, because there is no need to perform the complex control for precisely capturing the rapid voltage drop, manufacturing is possible at a lower cost compared to conventional lithium-ion batteries.

In the discharge curve of the lithium-ion battery 1 according to one or more embodiments, the voltage drop at the final stage of discharge becomes slow due to the lower-stage plateau appearing. Therefore, for example, the detector 110 can detect a point when the battery voltage becomes a potential where the lower-stage plateau appears (near 1.5 V in the discharge curve illustrated by the solid line in FIG. 6), and the controller 120 can stop discharge of the lithium-ion battery 1 when this point is detected by the detector 110. Even when configured in this manner, the danger of over-discharge can be avoided because the voltage drop is slower near the point when the battery voltage becomes the potential where the lower-stage plateau appears.

Embodiments of the present invention will be described below by a specific working example, but the invention is not limited thereto.

The positive electrode 10 may use polyaniline as the positive electrode active material, the negative electrode 20 may use non-graphitizable carbon (hard carbon) as the negative electrode active material (first negative electrode active material) whose lithium-ion absorption potential is 0.4 V (vs. Li/Li⁺) or less and LTO as the negative electrode active material (second negative electrode active material) whose lithium-ion absorption potential is higher than 0.4 V (vs. Li/Li⁺); the lithium-ion battery 1 may be assembled after the lithium ions are intercalated in the negative electrode 20, and a charge and discharge characteristic may be evaluated by performing a charge and discharge test.

For example, first, the positive electrode 10 may be produced.

Polyaniline applied with a de-doping treatment may be used as the positive electrode active material, acetylene black may be used as the conductive additive, and PTFE may be used as the binder resin; these may be mixed at a ratio of positive electrode active material: conductive additive : binder resin = 8:1:1 and kneaded in a mortar to prepare the positive electrode active material slurry.

Next, using a mesh of aluminum (thickness: 100 µm) as the positive electrode current collector 11, the produced positive electrode active material slurry may be drawn out in a sheet shape, placed on the positive electrode current collector 11, and molded by applying a pressure of 10 MPa to form the positive electrode active material layer 12 on the top surface of the positive electrode current collector 11. This may then be punched out in a circular shape of a diameter of 15 mm to prepare the positive electrode 10 of the circular shape. This may afterward be dried under reduced pressure for twenty-four hours at 100°C to sufficiently remove moisture.

Next, the negative electrode 20 may be produced.

A non-graphitizable carbon whose lithium-ion absorption potential is 0.2 V (vs. Li/Li⁺) may be used as the first negative electrode active material, an LTO whose lithium-ion absorption potential is 1.55 V (vs. Li/Li⁺) may be used as the second negative electrode active material, acetylene black may be used as the conductive additive, and PVdF may be used as the binder resin; these are mixed at a ratio of first negative electrode active material: second negative electrode active material: conductive additive : binder resin = 4:3:2:1 and dispersed in an n-methylpyrrolidone (NMP) solvent to prepare the negative electrode active material slurry.

Next, using a copper foil (thickness: 100 µm) as the negative electrode current collector 21, the produced negative electrode active material slurry may be coated on the negative electrode current collector 21, dried, and applied with a press to form the negative electrode active material layer 22 on the top surface of the negative electrode current collector 21. This may then be punched out in a circular shape of a diameter of 15 mm to prepare the negative electrode 20 of the circular shape. This may afterward be dried under reduced pressure for twenty-four hours at 100°C to sufficiently remove moisture.

Next, an assembly operation may be performed to prepare the lithium-ion battery 1. The assembly operation may be performed entirely in an argon atmosphere (specifically, in a glove box filled with argon gas).

A bipolar flat cell may be used as an evaluation cell, a cellulose-based film of a circular shape (diameter: 20 mm) may be used as the separator 30, and LiPF₆ (electrolyte) dissolved in an EC+EMC solution (solvent) (electrolyte concentration: 1 mol/L) may be used as the non-aqueous electrolyte.

Furthermore, first, for characteristic evaluation of the negative electrode 20, a cell (a half cell whose negative electrode is metallic lithium) may be configured by placing the separator 30 on Li foil punched out in a circular shape of 15 mm, dripping the non-aqueous electrolyte on this separator 30, and placing the produced negative electrode 20 described above on the separator 30 impregnated with the non-aqueous electrolyte.

Next, the lithium ions may be intercalated in the negative electrode 20 by shorting the Li foil (positive electrode) with the negative electrode 20 with a resistance of about 0.1 Ω.

Next, the lithium-ion battery 1 ("lithium-ion battery of a working example") may be produced by disassembling the cell, removing the intercalated negative electrode 20, and interposing the separator 30 impregnated with the non-aqueous electrolyte between the removed negative electrode 20 and the produced positive electrode 10 described above.

Next, a charge and discharge test of the half cell using the negative electrode 20 (negative electrode of the working example) may be performed using a charge and discharge testing device, and a charge and discharge characteristic of the negative electrode 20 may be evaluated.

Specifically, first, a negative electrode of the half cell (that is, the negative electrode of the working example) may be connected to a plus electrode of the charge and discharge testing device, and a positive electrode of the half cell may be connected to a minus electrode of the charge and discharge testing device.

Next, a charge and discharge current: 1 mA, an upper limit voltage: 3 V, and a lower limit voltage: 0.03 V may be set as test conditions, and the charge and discharge test may be performed by a constant current method. Test results thereof plotted by being corrected into corresponding specific capacities are illustrated in FIG. 4.

In FIG. 5, for comparison, a negative electrode (referred to hereinbelow as a "negative electrode of a comparative example") of the same configuration as the negative electrode of the working example other than using the non-graphitizable carbon as the negative electrode active material is produced, and the charge and discharge test is performed in the same method as the half cell using the negative electrode of the working example by configuring a half cell using the negative electrode of the comparative example in the same manner as the half cell using the negative electrode of the working example. Results of the comparative example are illustrated in FIG. 5.

As illustrated in FIG. 5, with the negative electrode of the comparative example, with a negative electrode using only the non-graphitizable carbon as the negative electrode active material, a plateau appears near 0.2 V and a lithium-ion absorption potential is near 0.2 V (vs. Li/Li⁺).

Meanwhile, according to one or more embodiments of the working example as illustrated in FIG. 4, with a negative electrode using the non-graphitizable carbon and the LTO as the negative electrode active material, in addition to the plateau near 0.2 V (vs. Li/Li⁺) due to the non-graphitizable carbon, a plateau near 1.5 V (vs. Li/Li⁺) due to the LTO also appears.

Furthermore, with the negative electrode using only the non-graphitizable carbon as the negative electrode active material (negative electrode of the comparative example), the lithium ions escape rapidly and a potential rises greatly at the final stage of discharge, but with the negative electrode using the non-graphitizable carbon and the LTO as the negative electrode active material (negative electrode according to one or more embodiments of the working example), a potential rise becomes slow even at the final stage of discharge due to the plateau near 1.5 V (vs. Li/Li⁺) appearing.

Discharge curves of the lithium-ion battery according to one or more embodiments of the working example and a lithium-ion battery of the comparative example (lithium-ion battery using the negative electrode of the comparative example) are illustrated in FIG. 6. An electrode weight of the lithium-ion battery of the working example and an electrode weight of the lithium-ion battery of the comparative example are not aligned accurately.

As illustrated by the dashed line in FIG. 6, with the conventional lithium-ion battery of the comparative example that uses only the non-graphtizablecarbon as the negative electrode active material, that is, where the plurality of types of negative electrode active materials whose lithium-ion absorption potentials mutually differ are not used, the battery voltage drops rapidly at the final stage of discharge in correspondence with deintercalation of the lithium-ions in the negative electrode. Therefore, to prevent over-discharge, there is a need to set the threshold voltage at the end of discharge in advance, with the allowance in consideration of variation, at 3 V or more (that is, end discharge at point Q or before point Q) or perform the complex control for precisely capturing the rapid voltage drop.

Meanwhile, as illustrated by the solid line in FIG. 6, with the lithium-ion battery according to one or more embodiments of the working example that uses the non-graphitizable carbon and the LTO as the negative electrode active material, that is, where the plurality of types of negative electrode active materials whose lithium-ion absorption potentials mutually differ are used, a plateau may also appear at the final stage of discharge. Because the voltage drop at the final stage of discharge becomes slow compared to that of the conventional lithium-ion battery, for example, voltage monitoring for over-discharge prevention becomes easy and safety increases. Therefore, for example, when discharge is stopped at the point P when the absolute value of the gradient of the discharge curve falls below the second threshold from among the points in the period at and after the point (for example, point Q) when the absolute value of the gradient of the discharge curve surpasses the first threshold, because there is the lower-stage plateau near 1.5 V, over-discharge does not occur at and below 1.5 V. Safety can be maintained even when, alternatively, discharge is stopped at the point when the potential at which the lower-stage plateau appears (1.5 V) is detected.

Here, in the lithium-ion battery according to one or more embodiments of the working example, a specific capacity of the first negative electrode active material may be greater than a specific capacity of the second negative electrode active material, and the first negative electrode active material and the second negative electrode material may be mixed at a substantially half and-half ratio of first negative electrode active material: second negative electrode active material = 4:3, but if the second negative electrode active material is mixed at a small ratio, for example, at a ratio such as first negative electrode active material: second negative electrode active material = 7:1, the large specific capacity of the first negative electrode active material can be utilized while making a second plateau (lower-stage plateau) appear. Because a period when an upper-stage plateau appears becomes long and a time until the lower-stage plateau appears can be extended, that is, because a period from discharge starting until the point P can be lengthened, an energy density can be further improved.

One or more embodiments of the power storage device (e.g., lithium-ion battery 1) described above may comprise the positive electrode 10, the negative electrode 20, and the non-aqueous electrolyte. The negative electrode 20 may include the plurality of types of negative electrode active materials whose lithium-ion absorption potentials mutually differ.

Therefore, for example, because the discharge curve of the negative electrode 20 has the plurality of plateaus, the voltage drop of the power storage device (e.g., lithium-ion battery 1) at the final stage of discharge becomes slow.

Because of this, for example, the danger of over-discharge can be avoided without setting in advance, with the allowance, the threshold voltage at the end of discharge or performing the complex control for precisely capturing the rapid voltage drop.

Furthermore, according to one or more embodiments of the power storage device (e.g., lithium-ion battery 1), the negative electrode 20 may include the first negative electrode active material and the second negative electrode active material whose lithium-ion absorption potential is higher than that of the first negative electrode active material. The first negative electrode active material can be configured to be the polyacenic organic semiconductor, the graphitic material, the graphitizable carbon, the non-graphitizable carbon, or the low-temperature co-fired carbon, and the second negative electrode active material can be configured to be the lithium titanium oxide expressed by the general formula Li₄Ti₅O₁₂ or the hydrogen titanium oxide expressed by the general formula H₂Ti₁₂O₂₅.

By configuring in this manner, for example, because the discharge curve of the negative electrode 20 has the plateau of two stages, the voltage drop of the power storage device (e.g., lithium-ion battery 1) at the final stage of discharge becomes slow.

One or more embodiments of the power storage device control device 100 may comprise the control means (e.g., controller 120) that controls discharge of the power storage device (e.g., lithium-ion battery 1) and the detection means (e.g., detector 110) that, by monitoring the discharge curve of the power storage device (e.g., lithium-ion battery 1), detects the point when the absolute value of the gradient of the discharge curve falls below the second threshold (≤ the first threshold) from among the points in the period at and after the absolute value of the gradient of the discharge curve surpasses the first threshold. The control means (e.g., controller 120) may be configured to stop discharge of the power storage device (e.g., lithium-ion battery 1) when the detection means (e.g., detector 110) detects the point P that falls below the second threshold.

Therefore, for example, because discharge of the power storage device (e.g., lithium-ion battery 1) can be stopped when the voltage drop of the power storage device (e.g., lithium-ion battery 1) at the final stage of discharge is slow, the danger of over-discharge can be avoided.

The negative electrode 20 may include three or more types of negative electrode active materials whose lithium-ion absorption potentials mutually differ.

Furthermore, the detector 110 may limit a period in which a process for detecting the point when the absolute value of the gradient of the discharge curve falls below the second threshold to only a period at and after the absolute value of the gradient of the discharge curve surpasses the first threshold and where the battery voltage is in a predetermined range. For example, with the discharge curve illustrated by the solid line in FIG. 6, the process of detecting the point when the absolute value of the gradient of the discharge curve falls below the second threshold is only performed in a period when the absolute value of the gradient of the discharge curve surpasses the first threshold (for example, point Q), and when the battery voltage is 1 to 2 V. By configuring in this manner, for example, not only can a process load be mitigated but only a desired point can be detected when the discharge curve of the lithium-ion battery 1 has a plateau of three or more stages.

That is, where the negative electrode 20 includes the three or more types of negative electrode active materials whose lithium-ion absorption potentials mutually differ, or where the discharge curve of the positive electrode 10 has the plurality of plateaus, the discharge curve of the lithium-ion battery 1 may have the plateau of three or more stages. Where the discharge curve of the lithium-ion battery 1 has the plateau of three or more stages, the absolute value of the gradient of the discharge curve has a plurality of points that fall below the second threshold in the period at and after the absolute value of the gradient of the discharge curve surpasses the first threshold. Therefore, for example, by limiting the period in which the detector 110 performs the process of detecting the point when the absolute value of the gradient of the discharge curve falls below the second threshold to the period at and after the point when the absolute value of the gradient of the discharge curve surpasses the first threshold and the period where the battery voltage is in the predetermined range, even if there are a plurality of points where the absolute value of the gradient of the discharge curve falls below the second threshold, only the desired point from among the plurality of points can be detected.

The embodiments herein disclosed are examples on all points and should not be considered limiting. Also, the features of these embodiments can be used in various combinations with each other, and are not intended to be limited to the specific combinations disclosed herein. The scope of the present invention is indicated not by the above description but by the scope of patent claims, and it is intended that meanings equivalent to the scope of patent claims and all modifications within the scope are included therein.

Although the disclosure has been described with respect to only a limited number of embodiments, those skilled in the art, having benefit of this disclosure, will appreciate that various other embodiments may be devised without departing from the scope of the present invention. Accordingly, the scope of the invention should be limited only by the attached claims.

### [Explanation of Reference Codes]

1 Lithium-ion battery (power storage device)
10 Positive electrode
20 Negative electrode
100 Power storage device control device
110 Detector (detection means)
120 Controller (control means)
P Point of falling below second threshold

## Claims

1. A power storage device, comprising:
a positive electrode (10);
a negative electrode (20); and
a non-aqueous electrolyte, wherein
the negative electrode (20) comprises a plurality of types of negative electrode active materials, each of the plurality of types having different lithium-ion absorption potentials.

2. The power storage device according to claim 1, wherein
the negative electrode (20) comprises a first negative electrode active material and a second negative electrode active material whose lithium-ion absorption potential is higher than that of the first negative electrode active material.

3. The power storage device according to claim 2, wherein the first negative electrode active material comprises at least one of a polyacenic organic semiconductor, a graphitic material, graphitizable carbon, non-graphitizable carbon, and low-temperature co-fired carbon.

4. The power storage device according to claim 2 or 3, wherein the first negative electrode active material is a material with a lithium-ion absorption potential of approximately 0.4V or less.

5. The power storage device according to any of claims 2 to 4, wherein the second negative electrode active material comprises at least one of a lithium titanium oxide expressed by the general formula Li₄Ti₅O₁₂, and a hydrogen titanium oxide expressed by the general formula H₂Ti₁₂O₂₅.

6. The power storage device according to any of claims 2 to 5, wherein the second negative electrode active material is a material with a lithium-ion absorption potential higher than approximately 0.4V.

7. The power storage device according to any of claims 1 to 6, wherein the positive electrode (10) comprises a positive electrode active material comprising at least one of an inorganic oxide and a conductive polymer.

8. A power storage device control device, comprising:
a controller (120) that controls discharge of a power storage device (1) according to any of claims 1 to 7; and
a detector (110) that monitors discharge of the power storage (1).

9. The power storage device control device according to claim 8, wherein
the detector (110) monitors a discharge curve of the power storage device (1) and detects a point (P) when an absolute value of a gradient of the discharge curve falls below a second threshold from among points in a period at and after the absolute value of the gradient of the discharge curve surpasses a first threshold,
the second threshold is less than or equal to the first threshold, and
the controller (120) stops discharge of the power storage device (1) when the detector (110) detects the point (P) that falls below the second threshold.

10. The power storage device control device according to claim 8 or 9, wherein
the detector (110) monitors a discharge curve of the power storage device, and detects a point (P) when a voltage of the power storage device (1) falls below a threshold, and
the controller (120) stops discharge of the power storage device when the detector (110) detects that the voltage has fallen below the threshold.
